# EUROPEAN PATENT APPLICATION

(11) **EP 4 697 377 A1**
(43) Date of publication of application: **18.02.2026**
(21) Application number: 24207420.1
(22) Date of filing: 18.10.2024
(51) Int. Cl.: H01L 21/48, H01L 21/56, H01L 23/31, H01L 23/498

(54) **METHOD OF MANUFACTURING FAN-OUT PACKAGING DEVICE AND FAN-OUT PACKAGING DEVICE MANUFACTURED THEREBY**

(30) Priority: 14.08.2024 KR 20240108929
(71) Applicant: Silicon Box Pte. Ltd., Singapore 529580 (SG)
(72) Inventor: SUTARDJA, Sehat, Las Vegas, NV 89109-1629 (US)
(74) Representative: Cabinet Beaumont

(57) **Abstract**

Disclosed is a method of manufacturing a fan-out packaging device, which is a method of manufacturing a packaging device using a wafer or panel level packaging process, the method including forming a first dielectric layer having a first via hole on a fan-out packaging substrate, forming a redistribution layer (RDL) on the first dielectric layer and the first via hole, forming a second dielectric layer having a second via hole formed on the redistribution layer, and forming a bump structure on the second dielectric layer and the second via hole so as to be connected to the redistribution layer, wherein the redistribution layer includes a metal sealing ring to extend a conductor path in a plating process.

## Description

### BACKGROUND OF THE INVENTION

### 1. Field of the invention

The present invention relates to a method of manufacturing a fan-out packaging device and a fan-out packaging device manufactured thereby, and more particularly to a method of manufacturing a fan-out packaging device having a conductor path extended by forming a metal sealing ring and a fan-out packaging device manufactured thereby.

### 2. Description of the Related Art

In general, a semiconductor packaging process includes wafer dicing, die attachment, die interconnection, molding, and packaging test steps.

In a conventional semiconductor packaging process, a wafer is cut and a packaging process is carried out on each cut wafer (substrate), whereas in recent years, a "wafer level packaging (WLP)" process is carried out while a die is kept in a wafer state, which has the advantage of reducing the cost of package production compared to the conventional process by carrying out a packaging process and a test at one time in the wafer state and then performing cutting on a per-die basis.

In addition, research on a panel level packaging (PLP) process, which is superior to the wafer level packaging process, is also active, and the PLP process has the advantage of further reducing production costs due to the larger number of dies that can be packaged compared to the WLP process.

Meanwhile, as semiconductor devices become highly integrated, high-performance, and miniaturized, various packaging technologies are evolving based on a wafer or panel level packaging method. Thereamong, fan-in wafer or panel level packaging and fan-out wafer or panel level packaging technologies are being actively researched.

In particular, the fan-out wafer or panel level packaging (hereinafter referred to as fan-out wafer level packaging for convenience and also referred to as "fan-out WLP" or "FO-WLP" as needed) technology is a fan-out method of increasing the number of I/O pins, and has the advantage of being able to extend a wiring formation range beyond the area of a die by using a redistribution layer (RDL) process, thus securing a larger wiring formation surface relative to the size of the die.

In the fan-out wafer level packaging process, the RDL process is performed to form a dielectric layer on the surface of the die, to form a wiring layer by copper plating, and to extend the wiring formation range beyond the die by repeatedly performing the above steps as needed.

In a conventional fan-out wafer level packaging process, a thin Cu seed layer sputtered with an adhesive layer such as Ti or TiW is used to support electroplating of the redistribution layer (RDL). That is, a sputtering process is used to form a thin Cu seed layer, and an electroplating process is performed to form the RDL on the top thereof.

In the above process, the thickness of the Cu seed layer is limited due to the throughput problem of sputtering equipment and the isotropic etching problem of an RDL line that occurs during etching of the seed layer. Especially for a fine RDL having 2 um L/S, the isotropic etching of the RDL line must be limited due to a narrow line width, which requires a thinner seed layer.

This requirement for a thinner seed layer limits the plating rate and increases the non-uniformity of the plating thickness. This reduces efficiency of the electroplating process, resulting in higher production costs and poorer quality.

There is also a need to improve local planarization in order to minimize the reduction in the thickness of the dielectric layer provided on the RDL line or the edge of a pad, which is critical to ensure electrical performance and structural stability.

In addition, insufficiency of a conductor path with increasing thickness of the seed layer increases the overall resistance, which allows for faster plating rates in an initial plating stage, but as the thickness increases, the conductor path may be insufficient, which may lead to poor electrical performance.

In addition, improving the quality of a plating layer is critical during a copper plating process. Conventionally, attempts were made to slow the plating rate or to improve the plating process conditions, which reduces the process speed and entails difficulty in achieving process reproducibility.

In addition, when forming a plurality of RDLs, a dielectric layer is formed between the plating processes, and if the quality of the plating layer is poor, unevenness of the dielectric layer may occur, which causes deterioration of surface topology and defects of a wiring layer by a subsequent RDL process.

As a result, contact resistance or impedance may be increased, whereby electrical performance at low operating frequencies may be lowered, which may lead to degradation in performance of a package.

### SUMMARY OF THE INVENTION

The present invention has been made in view of the above problems, and it is an object of the present invention to provide a method of manufacturing a fan-out packaging device capable of improving local planarization, extending a conductor path, and increasing efficiency of an electroplating process by forming a metal sealing ring and a fan-out packaging device manufactured thereby.

In accordance with one aspect of the present invention, the above and other objects can be accomplished by the provision of a method of manufacturing a fan-out packaging device, which is a method of manufacturing a packaging device using a wafer or panel level packaging process, the method including forming a first dielectric layer having a first via hole on a fan-out packaging substrate, forming a redistribution layer (RDL) on the first dielectric layer and the first via hole, forming a second dielectric layer having a second via hole formed on the redistribution layer, and forming a bump structure on the second dielectric layer and the second via hole so as to be connected to the redistribution layer, wherein the redistribution layer includes a metal sealing ring to extend a conductor path in a plating process.

In accordance with another aspect of the present invention, there is provided a fan-out packaging device, which is a packaging device using a wafer or panel level packaging process, the fan-out packaging device including a fan-out packaging substrate, a first dielectric layer formed on the fan-out packaging substrate, the first dielectric layer including a first via hole formed by patterning, the first via hole being configured to expose a signal pad and a ground pad of a die, a redistribution layer (RDL) formed on the first dielectric layer and the first via hole, a second dielectric layer formed on the redistribution layer, the second dielectric layer including a second via hole formed by patterning, the second via hole being configured to expose a part of the redistribution layer, and a bump structure formed on the second dielectric layer and the second via hole, the bump structure being connected to the redistribution layer, wherein the redistribution layer includes a metal sealing ring to extend a conductor path in a plating process.

The metal sealing ring may be formed along the edge of a fan-out area of the fan-out packaging substrate.

A first connection line may be formed to electrically connect metal sealing rings formed around the edges of adjacent fan-out areas to each other. In addition, a second connection line connected to the metal sealing ring may be further formed such that the conductor path extends to an inactive area outside the fan-out area.

The second connection line may be formed along the perimeter of the metal sealing ring, and may be formed so as to extend in a direction toward the edge of the inactive area. In addition, the second connection line may be formed oppositely along the perimeter of the metal sealing ring, and may be formed discontinuously.

In addition, a third connection line may be formed to connect a GND pad of the die and the metal sealing ring to each other. In addition, a fourth connection line may be formed to connect a GND seal ring of the die and the metal sealing ring to each other. In addition, a fifth connection line may be formed to connect a GND plane of the redistribution layer and the metal sealing ring to each other.

The third connection line configured to connect the GND pad of the die and the metal sealing ring to each other, the fourth connection line configured to connect the GND seal ring of the die and the metal sealing ring to each other, and the fifth connection line configured to connect the GND plane of the redistribution layer and the metal sealing ring to each other may all be formed, or one or more of the third connection line to the fifth connection line may be selectively formed.

The second connection line connected to the metal sealing ring may be further formed such that the conductor path extends to the inactive area outside the fan-out area.

A multiple redistribution layer/dielectric layer may be implemented by repeating the step of forming the first dielectric layer or the step of forming the redistribution layer.

Metal sealing rings formed in redistribution layers constituting the multiple redistribution layer may be electrically connected to each other via a first vertical connection line.

The metal sealing ring may be formed in one surface or both surfaces of the redistribution layer, and when formed in both surfaces of the redistribution layer, the metal sealing rings may be electrically connected to each other via a second vertical connection line.

### BRIEF DESCRIPTION OF THE DRAWINGS

FIGS. 1A, 1B, 1C, 1D and 1E are side schematic views showing a method of manufacturing a fan-out packaging device according to an embodiment of the present invention;
FIG. 2 is a schematic view showing a fan-out packaging device according to an embodiment of the present invention;
FIG. 3 is a schematic view showing the state in which a metal sealing ring is formed on a fan-out packaging substrate according to an embodiment of the present invention;
FIG. 4 is a schematic view showing the state in which a metal sealing ring and a connection line are formed on a fan-out packaging substrate according to an embodiment of the present invention;
FIG. 5 is a schematic view showing a fan-out packaging device according to another embodiment of the present invention;
FIG. 6 is a schematic view showing the state in which a metal sealing ring and a connection line are formed on a fan-out packaging substrate according to another embodiment of the present invention;
FIG. 7 is a schematic view showing the state in which a metal sealing ring and a connection line are formed on a fan-out packaging substrate according to another embodiment of the present invention; and
FIG. 8 is a schematic view showing a fan-out packaging device according to another embodiment of the present invention.

### DETAILED DESCRIPTION OF THE PREFERRED EMBODIMENTS

The present invention relates to a method of manufacturing a fan-out packaging device and a fan-out packaging device manufactured thereby, wherein a metal sealing ring is formed to improve local planarization, to extend a conductor path, and to increase efficiency of an electroplating process.

Therefore, the present invention has the advantage of improving electrical performance, structural stability, and productivity in a fan-out packaging process.

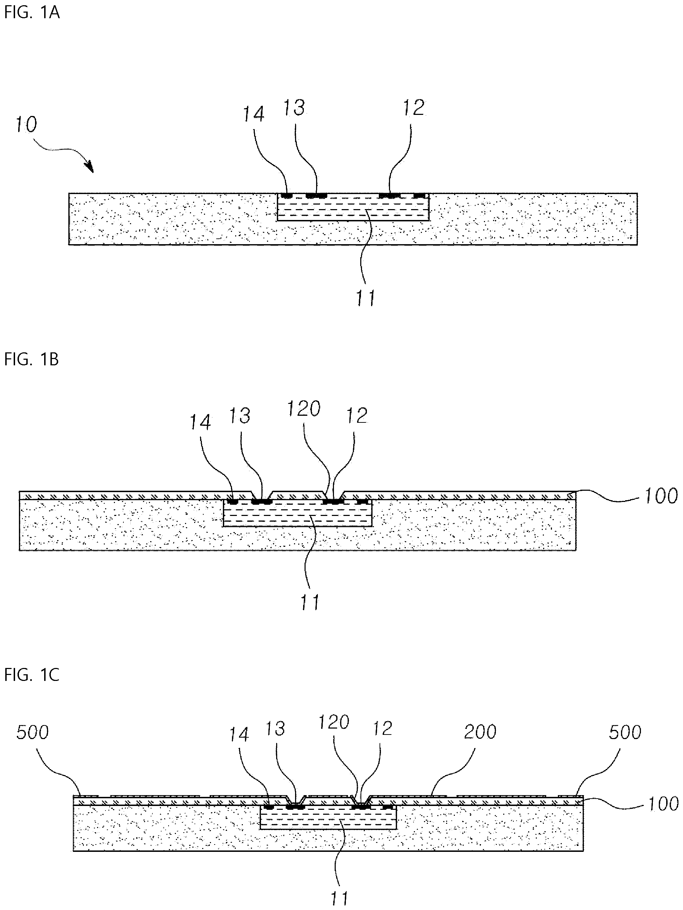

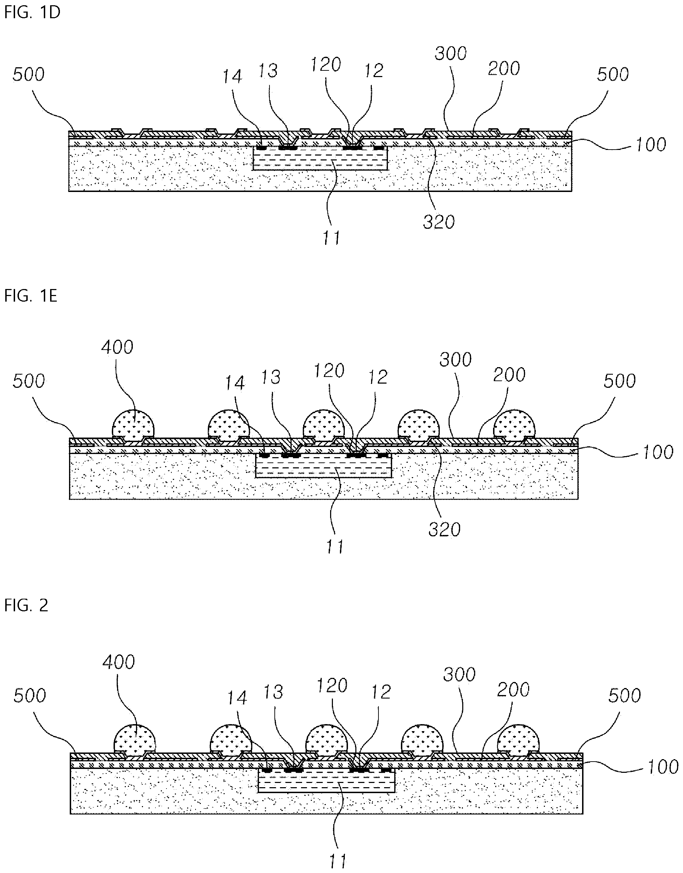

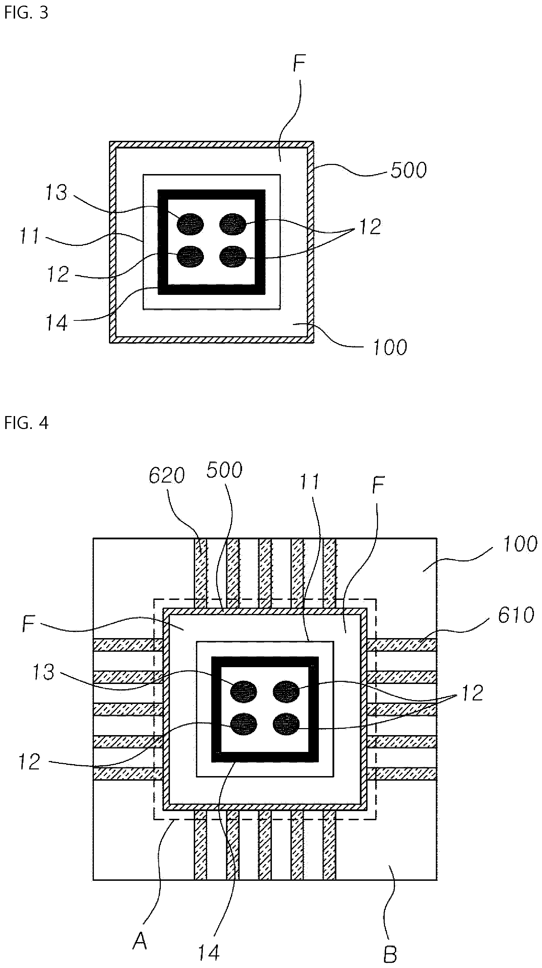

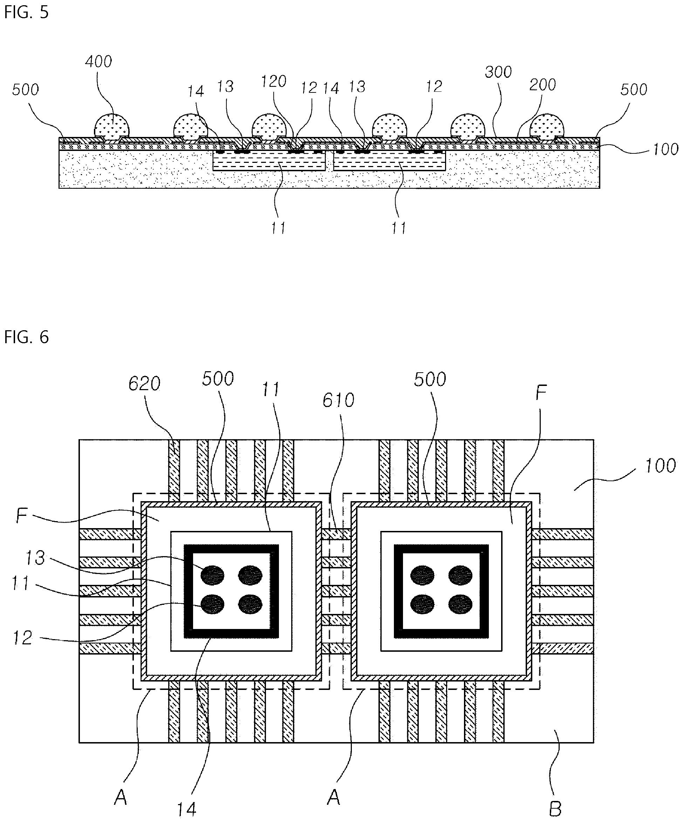

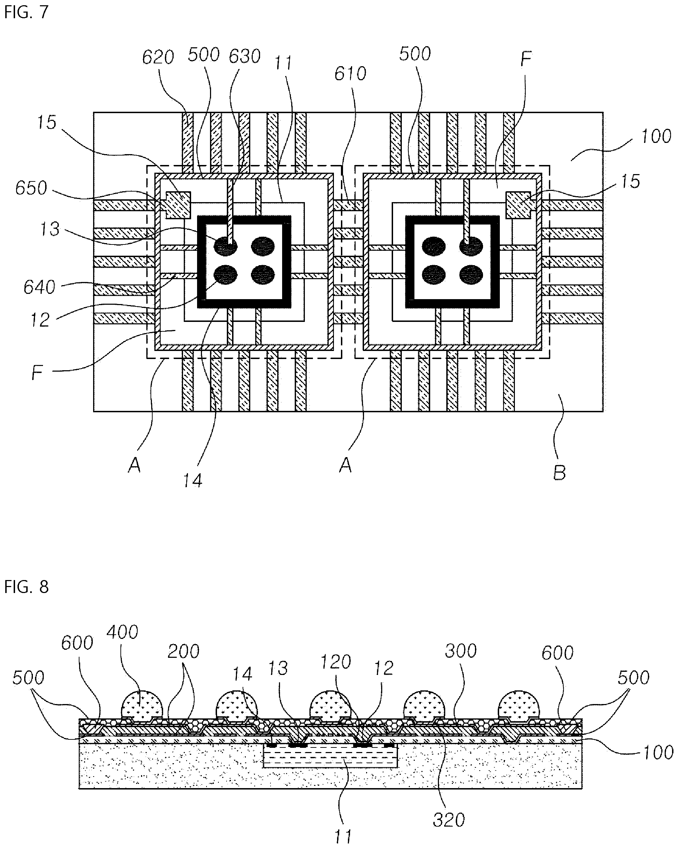

Hereinafter, embodiments of the present invention will be described in detail with reference to the accompanying drawings. FIGS. 1A, 1B, 1C, 1D and 1E are side schematic views showing a method of manufacturing a fan-out packaging device according to an embodiment of the present invention, FIG. 2 is a schematic view showing a fan-out packaging device according to an embodiment of the present invention, FIG. 3 is a schematic view showing the state in which a metal sealing ring is formed on a fan-out packaging substrate according to an embodiment of the present invention, FIG. 4 is a schematic view showing the state in which the metal sealing ring and a connection line are formed on the fan-out packaging substrate according to the embodiment of the present invention, FIG. 5 is a schematic view showing a fan-out packaging device according to another embodiment of the present invention, FIG. 6 is a schematic view showing the state in which a metal sealing ring and a connection line are formed on the fan-out packaging substrate according to the other embodiment of the present invention, FIG. 7 is a schematic view showing the state in which a metal sealing ring and a connection line are formed on a fan-out packaging substrate according to another embodiment of the present invention, and FIG. 8 is a schematic view showing a fan-out packaging device according to another embodiment of the present invention.

As shown, a method of manufacturing a fan-out packaging device according to an embodiment of the present invention, which is a method of manufacturing a packaging device using a wafer or panel level packaging process, includes a step of forming a first dielectric layer 100 having a first via hole 120 on a fan-out packaging substrate 10, a step of forming a redistribution layer (RDL) 200 on the first dielectric layer 100 and the first via hole 120, a step of forming a second dielectric layer 300 having a second via hole 320 on the redistribution layer 200, and a step of forming a bump structure 400 on the second dielectric layer 300 and the second via hole 320 so as to be connected to the redistribution layer 200, wherein the redistribution layer 200 includes a metal sealing ring 500 to extend a conductor path in a plating process.

A fan-out packaging device according to an embodiment of the present invention manufactured by the method of manufacturing the fan-out packaging device, which is a packaging device using a wafer or panel level packaging process, includes a fan-out packaging substrate 10, a first dielectric layer 100 formed on the fan-out packaging substrate 10, the first dielectric layer including a first via hole 120 formed by patterning, the first via hole being configured to expose a signal pad and a ground pad of a die 11, a redistribution layer (RDL) 200 formed on the first dielectric layer 100 and the first via hole 120, a second dielectric layer 300 formed on the redistribution layer 200, the second dielectric layer including a second via hole 320 formed by patterning, the second via hole being configured to expose a part of the redistribution layer 200, and a bump structure 400 formed on the second dielectric layer and the second via hole 320, the bump structure being connected to the redistribution layer 200, wherein the redistribution layer 200 includes a metal sealing ring 500 to extend a conductor path in a plating process.

In the present invention, a packaging device is manufactured using a wafer or panel level packaging process, wherein, first, a first dielectric layer 100 having a first via hole 120 is formed on a fan-out packaging substrate 10 (FIGs. 1A and 1B).

The fan-out packaging substrate 10 according to the embodiment of the present invention is a wafer or a substrate on which a single chip or a plurality of chip arrays is formed or is configured such that such a chip is diced, is disposed on a wafer or a panel by reconstitution, and is embedded using an epoxy molding compound (EMC). In the present invention, the terms "chip" and "die" 11 are used interchangeably.

As the result of implementing the embedded die 11 on the wafer or the panel, as described above, an input/output (I/O) signal pad 12 and a GND pad 13 of the die 11 are exposed, the area other than the signal pad 12 and the GND pad 13 may be provided after passivation, and the area outside the die 11 is provided as a fan-out area F.

In an embodiment of the present invention, the first dielectric layer 100 is formed on the fan-out packaging substrate 10 including the embedded die 11 reconstituted on the wafer or the panel, and the first via hole 120 is formed in the first dielectric layer 100 in order to expose necessary areas, such as the input/output (I/O) signal pad 12 and the GND pad 13 of the die 11. The first via hole 120 may be formed in areas other than the die 11 area and the fan-out area F, in addition to the above position.

The first dielectric layer 100 is made of an organic or inorganic dielectric material, and may be made of a polymer material, such as polyimide, polybenzoxazole (PBO), or benzocyclobutene (BCB), or may be made of an inorganic material, such as an oxide or nitride. Preferably, silicon nitride or silicon oxide is used. In addition, as various embodiments, an oxide, such as SiO₂, SiOₓ, Al₂O₃, ZrO₂, or Ta₂O₅, or a nitride, such as SiNₓ, Si₃N₄, ZrN, AlN, BN, or TaN, may be used, and a mixture of two or more materials may be used as needed. In addition, the first dielectric layer may be made of the same kind of material as a second dielectric layer 300, a description of which will follow, or may be made of a different kind of material from the second dielectric layer.

The dielectric layer may be formed by a process, such as spin coating, chemical vapor deposition (CVD), sputtering, or lamination, or a combination thereof, and may be formed by an appropriate physical or chemical deposition process.

The first via hole 120 is formed by patterning the first dielectric layer 100. The first via hole 120 is formed by an etching process by a patterning process, and the first via hole 120 is filled with a metal to form an electrical connection passage between the upper and lower components.

A plurality of the first via holes 120 is formed in the first dielectric layer 100, whereby a part of the die area and the fan-out area F or an active area A and an inactive area B is exposed. For example, the input/output (I/O) signal pad 12 and the GND pad 13 of the die 11 are exposed such that the signal pad 12 and the GND pad 13 are connected to the redistribution layer 200.

The first via hole 120 may be filled with various metal materials, such as aluminum (Al), tungsten (W), titanium (Ti), and copper (Cu), by sputtering, atomic layer deposition (ALD), CVD, or electroplating.

In the embodiment of the present invention, electroplating with good step coverage, low cost, and high productivity is used, and copper is used as the metal material.

Subsequently, a redistribution layer (RDL) 200 is formed on the first dielectric layer 100 and the first via hole 120 (FIG. 1C), whereby the redistribution layer 200 is electrically connected to the signal pad 12 and the GND pad 13 of the die 11. The redistribution layer 200 is implemented by forming a metal layer on the first dielectric layer 100 during the process of filling the first via hole 120 with the metal material or after forming the first via hole 120 and forming a metallization pattern thereof.

In the redistribution layer 200 according to the embodiment of the present invention, a copper layer is formed by electroplating, and a signal line for rearranging an electrical connection wire of the signal pad 12 or the GND pad 13 exposed from the die 11 is formed by a patterning process and an etching process thereof.

The redistribution layer 200 may be implemented as a single, multiple, or double-sided redistribution layer 200. That is, a multiple redistribution layer/dielectric layer is implemented by repeated formation of a dielectric layer and a metal layer (by repeating the first dielectric llayer formation process or the redistribution layer formation process) to form a redistribution signal line to the fan-out area F.

In the present invention, particularly in a process of forming the redistribution layer 200, a metal sealing ring 500 is formed so as to be included in the redistribution layer 200.

The metal sealing ring 500 is formed by a simultaneous or continuous process in the process of forming the redistribution layer 200, and may be formed so as to be sealed (as a sealing ring) in a certain area on the fan-out packaging substrate 10, i.e., as a closed curved surface or a closed figure forming a closed circuit.

Preferably, the metal sealing ring is formed in a shape that surrounds the fan-out area F or surrounds the fan-out packaging substrate 10, and may be formed as a double or triple closed circuit as needed. This provides a sealing ring sealed in a certain area while avoiding overlap with an existing redistributed wiring circuit.

As the result of forming such a metal sealing ring 500, the reduced thickness of the dielectric layer formed at an RDL line or the edge of the pad is compensated for to provide a local planarization surface, thereby providing an electrical and structural planarization surface.

In addition, the metal sealing ring 500 provides an additional conductor path during the formation of the redistribution layer 200, which reduces the overall resistance as the thickness of a seed layer increases, thereby increasing the efficiency of the electroplating process and helping to accelerate the plating rate.

In general, the seed layer provides a path for current to flow in the electroplating process, and in the electroplating process, a sufficient conductor path is required to allow current to flow evenly. That is, if the conductor path is insufficient, current does not flow efficiently, resulting in slower plating rate and increased unevenness of the plating thickness.

Therefore, the metal sealing ring 500 according to the present invention provides an additional conductor path, which helps evenly distribute the current in the seed layer over a larger area. Especially when the thickness of the seed layer is small, the conductor path may be insufficient, which is solved by adding the sealed type metal sealing ring 500 according to the present invention.

In addition, insufficiency of the conductor path with increasing thickness of the seed layer increases the overall resistance, which allows for faster plating rates in an initial plating stage, but as the thickness increases, the conductor path may be insufficient, which may lead to poor electrical performance. In the present invention, however, the metal sealing ring 500 reduces the overall resistance, allowing current to flow more efficiently in the electroplating process, resulting in faster plating rates and improved uniformity of the plating thickness.

That is, the sealed type metal sealing ring 500 according to the present invention extends the conductor path by providing an additional path for current to flow along with the seed layer, which reduces the overall resistance when the thickness of the seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 200.

Particularly, in the wafer or panel level packaging process, the additional formation of the sealed type metal sealing ring 500 according to the present invention contributes to increasing the process speed, reducing production costs, and thus reducing the overall package production costs.

Furthermore, in the case of forming a multiple redistribution layer 200, the sealed type metal sealing ring 500 according to the present invention prevents unevenness of the dielectric layer formed between the redistribution layers 200, thereby reducing defects of a wiring layer in a subsequent redistribution layer 200 formation process.

In addition, the reproducibility of the electroplating process is enhanced by the sealed type metal sealing ring 500 according to the present invention, which keeps the process conditions constant to provide a high quality plating layer, while enhancing the overall stability of the packaging structure to increase the resistance to mechanical and thermal stresses.

Furthermore, in such a multiple redistribution layer 200 structure, an initial short circuit path is provided by connecting a GND plane of each layer to the sealed type metal sealing ring 500, which optimizes electrical performance and increases the reliability of signal transmission.

Subsequently, a second dielectric layer 300 having a second via hole 320 formed on the redistribution layer 200 including the metal sealing ring 500 is formed, and a bump structure 400 is formed on the second dielectric layer 300 and the second via hole 320 so as to be connected to the redistribution layer 200 (FIGs. 1D and 1E).

The second dielectric layer 300 is made of a material identical or similar to the material of the first dielectric layer 100 and is formed by a process identical or similar to the process by which the first dielectric layer 100 is formed, and is patterned to form the second via hole 320. The bump structure 400, which is connected to the redistribution layer 200, is formed on the second via hole 320.

In the case of forming a multiple redistribution layer 200, the second dielectric layer 300 is patterned to form a via hole in the same manner as in the first dielectric layer 100, redistribution layers 200 are formed through a plating process, and the redistribution layers 200 are connected to each other.

Here, in the case of forming a multiple redistribution layer 200, a metal sealing ring 500 is formed in each redistribution layer 200, and the metal sealing rings 500 formed in the respective redistribution layers 200 are electrically connected to each other by a vertical connection line (see FIG. 8).

In the embodiments of FIGs. 1E and FIG. 2, a first dielectric layer 100 is formed on a fan-out packaging substrate 10 including one embedded die 11, a redistribution layer 200 is formed on the first dielectric layer and a via hole thereof, a second dielectric layer 300 and a second via hole 320 are formed on the redistribution layer, and a bump structure 400 is formed on the second via hole 320 so as to be connected to the redistribution layer 200.

In the bump structure 400 of the embodiment of the present invention, under bump metallization (UBM) (Ti/Cu layer deposition and patterning) is formed on the second via hole 320 formed in the second dielectric layer 300, and a solder bump is formed by solder plating, photoresist removal, unnecessary metal layer removal, and reflow. In the present invention, the solder bump and the UBM are referred to as the bump structure 400 for convenience.

After the solder bump is formed at the wafer or panel level, as described above, an additional or general packaging process may be performed, and dicing may be performed for division between fan-out packaging devices on a per-unit or per-module basis.

Hereinafter, specific embodiments of the present invention will be described with reference to the accompanying drawings.

FIG. 3 is a schematic view showing the state in which a metal sealing ring 500 is formed on a fan-out packaging substrate 10 according to an embodiment of the present invention, wherein the metal sealing ring 500 according to the embodiment of the present invention is formed along the edge of a fan-out area F of the fan-out packaging substrate 10.

According to the embodiment of FIG. 3, a first dielectric layer 100 and a first via hole 120 are formed on a fan-out packaging substrate 10 in which a single die 11 is embedded, a metal sealing ring 500 is formed along the edge of a fan-out area F in a process of forming a redistribution layer 200 for forming a predetermined redistribution line.

According to the embodiment of the present invention, the redistribution layer 200 is formed by an electroplating process, and the metal sealing ring 500 is also formed by an electroplating process, wherein copper is used as a metal material. In this figure, depiction of the redistribution line is omitted.

The metal sealing ring 500 according to the embodiment of the present invention is formed around the edge of the fan-out area F to compensate for the reduced thickness of the dielectric layer at the edge, thereby providing a local planarization surface.

The metal sealing ring 500 extends an additional conductor path during the formation of the redistribution layer 200, which reduces the overall resistance when the thickness of the seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 200.

FIG. 4 is a schematic view showing the state in which a metal sealing ring 500 and a connection line are formed on a fan-out packaging substrate 10 according to an embodiment of the present invention, wherein the metal sealing ring 500 according to the embodiment of the present invention is formed along the edge of a fan-out area F of the fan-out packaging substrate 10, and a conductor path extends to an inactive area B outside the fan-out area F.

According to the embodiment of FIG. 4, a first dielectric layer 100 and a first via hole 120 are formed on a fan-out packaging substrate 10 in which a single die 11 is embedded, and in a process of forming a redistribution layer 200 for forming a predetermined redistribution line, a metal sealing ring 500 is formed along the edge of a fan-out area F, and a second connection line 620 is formed such that a conductor path extends to an inactive area B outside the fan-out area F.

According to the embodiment of the present invention, the redistribution layer 200 is formed by an electroplating process, and the metal sealing ring 500 is also formed by an electroplating process, wherein copper is used as a metal material. In this figure, depiction of the redistribution line is omitted.

In addition, the second connection line 620 is formed along the perimeter of the metal sealing ring 500, and is formed so as to extend in a direction toward the edge of the inactive area B.

In addition, the second connection line 620 is formed along the perimeter of the metal sealing ring 500 in opposite directions, and is discontinuously formed.

That is, the second connection line 620 is formed so as to extend along the perimeter of the inactive area B outside the fan-out area F, or is formed oppositely and discontinuously along the perimeter of the inactive area, such that the conductor path is evenly distributed throughout the fan-out area F and the area outside thereof, thereby improving structural stability of the packaging structure and plating uniformity.

The metal sealing ring 500 and the second connection line 620 according to the embodiment of the present invention are formed around the edge of the fan-out area F and in the inactive area B outside the fan-out area F to compensate for the reduced thickness of the dielectric layer at the edge, thereby providing a local planarization surface.

The metal sealing ring 500 and the second connection line 620 extend an additional conductor path during the formation of the redistribution layer 200, which reduces the overall resistance when the thickness of a seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 200.

In addition, as the result of forming the second connection line 620 in the inactive area B outside the fan-out area F, the overall stability of the packaging structure is enhanced, whereby resistance to mechanical and thermal stresses is increased.

FIG. 5 is a schematic view showing a fan-out packaging device according to another embodiment of the present invention, and FIG. 6 is a schematic view showing the state in which a metal sealing ring 500 and a connection line are formed on a fan-out packaging substrate 10 according to another embodiment of the present invention.

According to the embodiment of FIGs. 5 and 6, two dies 11 are included, a metal sealing ring 500 is formed along the edge of a fan-out area F of each die 11, and a first connection line 610 is formed to electrically connect the metal sealing rings 500 to each other.

According to the embodiments of FIGs. 5 and 6, a first dielectric layer 100 and a first via hole 120 are formed on a fan-out packaging substrate 10 in which two dies 11 are embedded, and in a process of forming a redistribution layer 200 for forming a predetermined redistribution line, a metal sealing ring 500 is formed along the edge of each fan-out area F, and a first connection line 610 is formed to electrically connect the metal sealing rings 500 to each other.

According to the embodiment of the present invention, the redistribution layer 200 is formed by an electroplating process, and the metal sealing ring 500 is also formed by an electroplating process, wherein copper is used as a metal material. In this figure, depiction of the redistribution line is omitted.

In addition, the first connection line 610 is formed along the perimeter of the metal sealing ring 500, and is formed so as to extend in a direction toward the edge of an inactive area B, and is discontinuously formed so as to be connected to the metal sealing ring 500 adjacent thereto.

Here, a second connection line 620 is formed along the perimeter of the metal sealing ring 500, is formed so as to extend in the direction toward the edge of the inactive area B, is formed oppositely along the perimeter of the metal sealing ring 500, and is formed discontinuously.

In the inactive area B outside the fan-out area F, the first connection line 610 and the second connection line 620 are formed so as to extend along the periphery of the metal sealing ring 500, or are formed oppositely and discontinuously along the perimeter thereof, such that a conductor path is evenly distributed throughout the fan-out area F and the area outside thereof, thereby improving structural stability of the packaging structure and plating uniformity.

That is, the first connection line 610 and the second connection line 620 are formed in the inactive area B, wherein the first connection line 610 connects the metal sealing rings 500 formed around the edges of the adjacent fan-out areas F to each other, and the second connection line 620 is formed in the inactive area B outside the remaining fan-out areas F. Here, when third and fourth embedded dies 11 are formed, the metal sealing rings 500 formed around the edge of each fan-out area F may be connected to each other via the first connection line 610, and the second connection line 620 is formed in the inactive area B of the edge of the fan-out packaging substrate 10.

The metal sealing ring 500, the first connection line 610, and the second connection line 620 according to the embodiment of the present invention are formed around the edge of the fan-out area F and in the inactive area B outside the fan-out area F to compensate for the reduced thickness of the dielectric layer at the edge, thereby providing a local planarization surface.

The metal sealing ring 500, the first connection line 610, and the second connection line 620 extend an additional conductor path during the formation of the redistribution layer 200, which reduces the overall resistance when the thickness of a seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 200.

In addition, as the result of forming the first connection line 610 and the second connection line 620 in the inactive area B outside the fan-out area F, the overall stability of the packaging structure is enhanced, whereby resistance to mechanical and thermal stresses is increased.

FIG. 7 is a schematic view showing the state in which a metal sealing ring 500 and a connection line are formed on a fan-out packaging substrate 10 according to another embodiment of the present invention.

In the embodiment of FIG. 7, a third connection line 630 is formed to connect a GND pad 13 of a die 11 and the metal sealing ring 500 to each other, a fourth connection line 640 is formed to connect a GND seal ring 14 of the die 11 and the metal sealing ring 500 to each other, and a fifth connection line 650 is formed to connect a GND plane 15 of a redistribution layer 200 and the metal sealing ring 500 to each other, as compared to the embodiment of FIG. 6.

All of the third connection line 630 to the fifth connection line 650 may be formed, or one or more thereof may be selectively formed, depending on packaging type or wiring environment.

Here, of course, a second connection line 620 connected to the metal sealing ring 500 may be formed so as to extend a conductor path to an inactive area B outside a fan-out area F, and when a plurality of embedded dies 11 is formed, a first connection line 610 may also be formed to electrically connect metal sealing rings formed around the edges of the respective fan-out areas F to each other.

Furthermore, in the redistribution layer 200 structure, an initial short circuit path is provided by connecting a GND plane 15 of each layer to the sealed type metal sealing ring 500, which optimizes electrical performance and increases the reliability of signal transmission.

As the result of forming the metal sealing ring 500 and the first connection line 610 to the fifth connection line 650 in accordance with the embodiment of the present invention, the conductor path is extended, and at the same time the reduced thickness of a dielectric layer at the edge is compensated for, thereby providing a local planarization surface.

That is, the metal sealing ring 500 and the first connection line 610 to the fifth connection line 650 extend an additional conductor path during the formation of the redistribution layer 200, which reduces the overall resistance when the thickness of a seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 200.

In addition, as the result of forming the first connection line 610 and the second connection line 620 in the inactive area B outside the fan-out area F together with the metal sealing ring 500, the overall stability of the packaging structure is enhanced, whereby resistance to mechanical and thermal stresses is increased.

FIG. 8 is a schematic view showing a fan-out packaging device according to another embodiment of the present invention. In the embodiment of FIG. 8, a multiple redistribution layer 200/dielectric layer is implemented as the result of a first dielectric layer 100 formation process or a redistribution layer 200 formation process being repeated, whereby the fan-out packaging device includes a fan-out packaging substrate/first dielectric layer/first redistribution layer 200/second dielectric layer 300/second redistribution layer 200/third dielectric layer/bump structure 400. The metal sealing rings 500 formed in the respective redistribution layers 200 may be electrically connected to each other via a first vertical connection line 660.

In addition, the metal sealing ring 500 may be formed in one surface or both surfaces of the redistribution layer 200, and when formed in both surfaces of the redistribution layer, the metal sealing rings may be electrically connected to each other via a second vertical connection line (not shown).

Furthermore, in such a multiple redistribution layer 200 structure, an initial short circuit path is provided by connecting a GND plane 15 of each layer to the sealed type metal sealing ring 500, which optimizes electrical performance and increases the reliability of signal transmission.

As is apparent from the above description, the metal sealing ring according to the present invention provides an additional conductor path, which helps evenly distribute the current in the seed layer over a larger area. Especially when the thickness of the seed layer is small, the conductor path may be insufficient; however, it is possible to extend the conductor path by adding the sealed type metal sealing ring according to the present invention.

In addition, the sealed type metal sealing ring according to the present invention extends the conductor path by providing an additional path for current to flow along with the seed layer, which reduces the overall resistance when the thickness of the seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer.

Particularly, in the wafer or panel level packaging process, the additional formation of the sealed type metal sealing ring according to the present invention contributes to increasing the process speed, reducing production costs, and thus reducing the overall package production costs.

Furthermore, in the case of forming a multiple redistribution layer, the sealed type metal sealing ring according to the present invention prevents unevenness of the dielectric layer formed between the redistribution layers, thereby reducing defects of a wiring layer in a subsequent redistribution layer formation process.

In addition, the reproducibility of the electroplating process is enhanced by the sealed type metal sealing ring according to the present invention, which keeps the process conditions constant to provide a high quality plating layer, while enhancing the overall stability of the packaging structure to increase the resistance to mechanical and thermal stresses.

Furthermore, in the redistribution layer structure according to the present invention, an initial short circuit path is provided by connecting the GND plane of each layer to the sealed type metal sealing ring, which optimizes electrical performance and increases the reliability of signal transmission.

## Claims

1. A method of manufacturing a fan-out packaging device, which is a method of manufacturing a packaging device using a wafer or panel level packaging process, the method comprising:
forming a first dielectric layer having a first via hole on a fan-out packaging substrate;
forming a redistribution layer (RDL) on the first dielectric layer and the first via hole;
forming a second dielectric layer having a second via hole formed on the redistribution layer; and
forming a bump structure on the second dielectric layer and the second via hole so as to be connected to the redistribution layer, wherein
the redistribution layer comprises a metal sealing ring to extend a conductor path in a plating process.

2. The method according to claim 1, wherein the metal sealing ring is formed along an edge of a fan-out area of the fan-out packaging substrate.

3. The method according to claim 2, wherein a first connection line is formed to electrically connect metal sealing rings formed around edges of adjacent fan-out areas to each other.

4. The method according to claim 3, wherein a second connection line connected to the metal sealing ring is further formed such that the conductor path extends to an inactive area outside the fan-out area.

5. The method according to claim 4, wherein the second connection line is formed along a perimeter of the metal sealing ring, and is formed so as to extend in a direction toward an edge of the inactive area.

6. The method according to claim 4, wherein the second connection line is formed oppositely along a perimeter of the metal sealing ring, and is formed discontinuously.

7. The method according to claim 3, wherein a third connection line is formed to connect a GND pad of a die and the metal sealing ring to each other.

8. The method according to claim 3, wherein a fourth connection line is formed to connect a GND seal ring of a die and the metal sealing ring to each other.

9. The method according to claim 3, wherein a fifth connection line is formed to connect a GND plane of the redistribution layer and the metal sealing ring to each other.

10. The method according to claim 3, wherein
a third connection line configured to connect a GND pad of a die and the metal sealing ring to each other, a fourth connection line configured to connect a GND seal ring of the die and the metal sealing ring to each other, and a fifth connection line configured to connect a GND plane of the redistribution layer and the metal sealing ring to each other are all formed, or
one or more of the third connection line to the fifth connection line are selectively formed.

11. The method according to claim 10, wherein a second connection line connected to the metal sealing ring is further formed such that the conductor path extends to an inactive area outside the fan-out area.

12. The method according to claim 1, wherein a multiple redistribution layer/dielectric layer is implemented by repeating the step of forming the first dielectric layer or the step of forming the redistribution layer.

13. The method according to claim 12, wherein metal sealing rings formed in redistribution layers constituting the multiple redistribution layer are electrically connected to each other via a first vertical connection line.

14. The method according to claim 1, wherein
the metal sealing ring is formed in one surface or both surfaces of the redistribution layer, and
when formed in both surfaces of the redistribution layer, the metal sealing rings are electrically connected to each other via a second vertical connection line.

15. A fan-out packaging device, which is a packaging device using a wafer or panel level packaging process, the fan-out packaging device comprising:
a fan-out packaging substrate;
a first dielectric layer formed on the fan-out packaging substrate, the first dielectric layer comprising a first via hole formed by patterning, the first via hole being configured to expose a signal pad and a ground pad of a die;
a redistribution layer (RDL) formed on the first dielectric layer and the first via hole;
a second dielectric layer formed on the redistribution layer, the second dielectric layer comprising a second via hole formed by patterning, the second via hole being configured to expose a part of the redistribution layer; and
a bump structure formed on the second dielectric layer and the second via hole, the bump structure being connected to the redistribution layer, wherein
the redistribution layer comprises a metal sealing ring to extend a conductor path in a plating process.
